Europäisches Patentamt

European Patent Office

Office européen des brevets

(11) Publication number: **0 203 231**
A1

# EUROPEAN PATENT APPLICATION

(21) Application number: **85303685.3**

(22) Date of filing: **24.05.85**

(51) Int. Cl.⁴: **H 01 L 29/90**

(43) Date of publication of application: **03.12.86**
**Bulletin 86/49**

(71) Applicant: **SEMITRON CRICKLADE LTD., Cricklade Swindon, Wiltshire SN6 6HQ (GB)**

(72) Inventor: **Wood, Michael John, Court Garden House 3 the Street, Uley Dursley Glougestershire (GB)**

(84) Designated Contracting States: **AT BE CH DE FR GB IT LI LU NL SE**

(74) Representative: **Mehl, Ernst, Dipl.-Ing., Postfach 22 01 76, D-8000 München 22 (DE)**

(54) **Transient absorption semiconductor device comprising at least one zenerdiode.**

(57) A transient absorption semiconductor device for presenting a relatively high impedance over a given range of applied voltage and for presenting a low impedance in response to transient voltage excursions from the given range should be improved. At least one Zener diode (A) and a negative resistance element (B) are integrated onto the same chip.

Semitron Cricklade Ltd.          Our Ref
Cricklade, Swindon,              VPA 85 P 8021 E
Wiltshire, SN6 6HQ

Transient Absorption Semiconductor Device Comprising
at least one Zener Diode

This invention relates to a transient absorption semiconductor device, for presenting a relatively high impedance over a given range of applied voltage and for
presenting a low impedance in response to transient voltage excursions from the given range, the device having
particular application as a protection device in an electrical circuit, for protecting the circuit by selectively
conducting transient surges in current flowing in the
circuit.

It is known that a PN junction in a semiconductor body
can be used to protect an electrical circuit from transient voltage surges. The PN junction is connected across
a voltage supply to the circuit such as to be reverse
biased. The breakdown voltage of the reverse biased junction is selected to be somewhat greater than the voltage
normally developed by the supply. Thus in normal use, the
junction does not conduct substantially but in the event
of a transient voltage surge which results in the supply
voltage exceeding the breakdown voltage, the reverse
biased junction breaks down and conducts the current
surge associated with the voltage surge, so as to protect
the circuit from the surge. The breakdown voltage is typically in the range 2 - 1000 V the value thereof being
selected for the junction concerned by control of the
doping levels utilised in manufacture of the junction.
For higher voltages in the aforementioned range of breakdown voltages the breakdown occurs by virtue of the Ava-

My 1 Dx / 02.05.1985

lanche effect whereas at lower voltages the Zener effect may predominate.

Typically the current flowing in the reverse biased junction prior to breakdown is of the order of 1 - 10 μA whereas after breakdown, heavy current surges with peak currents of 25 amps or more may flow. The junction does exhibit a finite impedance upon breakdown and the voltage across the broken down junction increases steadily with increased current flow through the junction. Thus, heavy current surges cause heating of the junction and this limits the surge current handling capacity of the device. The current handling capacity can be increased by mounting the junction in a heat dissipating capsule but with the disadvantage of increasing the bulk of the device and making it unsuitable for direct mounting on a printed circuit board. Also, because of the finite impedance of the broken down junction, the voltage across the device rises above the voltage occurring at breakdown as the current increases and the voltage may rise to a level which is unsafe for the circuit being protected.

For protecting an a.c. circuit, it is known to connect two such transient absorption devices in series with their polarities arranged in opposite senses, so that the PN junctions are respectively reverse biased by positive and negative going portions of the a.c. waveform. The junctions thus respectively provide surge protection for positive and negative going voltage transients. It is known also to integrate the two junctions into a single package, either by electrically connecting together two PN junctions, or by taking a P type substrate and doping N type regions into opposite surfaces thereof, so as to form the two PN junctions. On breakdown of either of the junctions, the device exhibits the aforementioned characteristic of increased high voltage with increasing surge current and thus suffers from the disadvantages hereinbefore mentioned.

European Patent Application No 82 304 718.8 (EP 0 088 179 A 2) describes a transient absorption semiconductor device, which comprises a thin planar semiconductor body of one conductivity type having regions of opposite conductivity type diffused into opposite surfaces thereof so as to define relatively closely spaced rectifying junctions which interact with one another when the device is subjected to an overvoltage causing the reverse biased one of the junctions to breakdown from a low to a relatively high conductivity state. With an increase in the magnitude of the current flowing in the device, the potential difference developed across the device decreases from the breakdown voltage but does not decrease below a set non-zero voltage.

Because the voltage drop across the device decreases after breakdown, the surge current handling capability of the device is increased and transient absorption devices can correspondingly be manufactured in smaller sizes than heretofore and with less associated heat dissipating encapsulation.

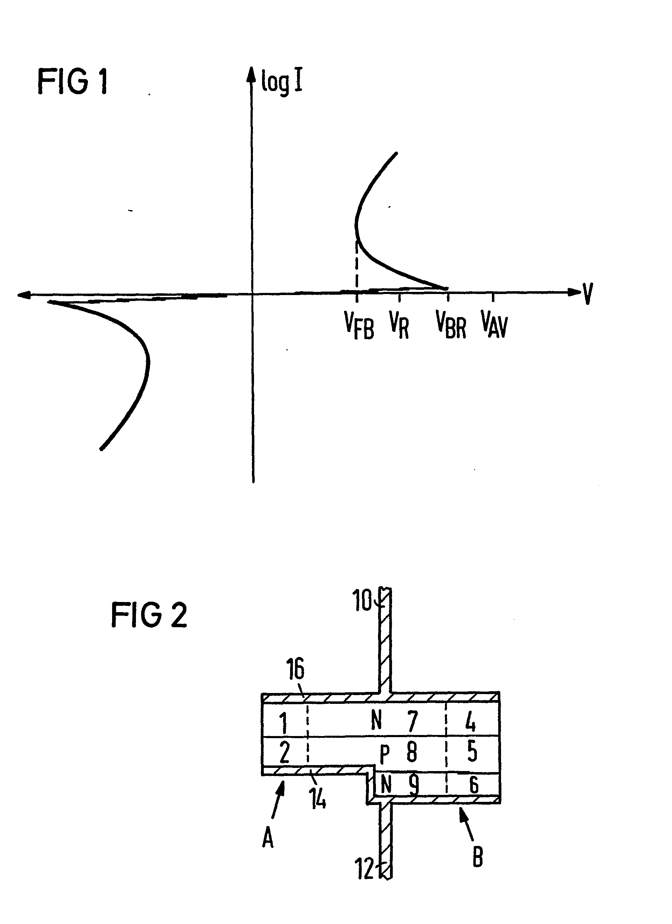

This device has proved excellent in many applications but has certain disadvantages. Figure 1 shows a typical V/I characteristic for this device. $V_{AV}$ is the avalanche voltage of the reverse biased junction, $V_{BR}$ the breakdown voltage of the device under specified conditions, $V_R$ the reverse 'stand-off' voltage and $V_{FB}$ the minimum voltage reached after switching. The device suffers for the fact that under certain conditions $V_{BR}$ is not equal to $V_{AV}$. This results in unnecessary lowering of $V_R$, and a reduction in the effective amount of 'fold-back' voltage ($V_{BR} - V_{FB}$) available. This discrepancy between $V_{AV}$ and $V_{BR}$ does not always exist, they can be the same value. In general it has been observed that the larger the device, the higher the bulk resistivity, and the narrower the diffusion base width the worse this effect. Thus the higher one wishes to make $V_{BR}$ the more difficult it is to make $V_{BR}$ equal to $V_{AV}$. It is believed that the difference between $V_{AV}$ and $V_{BR}$ is determined by the low current gain of the transistor structure and the difference between $V_{AV}$ and $V_{BR}$ is determined by the high current gain. In the extreme this can result in a limitation to the practical value of $V_{BR}$ that can be obtained with a device comprising one device element only, and higher voltages must be obtained by placing a multiplicity of elements in series. Certain applications require that should a device fail as a result of its rating being exceeded it should fail into a short circuit condition. When a multiplicity of elements are placed in series there is a strong probability that, when the device rating is exceeded, not all the series elements will fail at the same time.

An additional disadvantage of the device which is bi-directional is that it is not possible to produce an analogous product to a unidirectional Zener diode.

The present invention provides an improved transient absorption device in which the aforementioned disadvantages are overcome. The device consists of one or more Zener diodes and a N-P-N negative resistance device integrated onto the same chip.

Those skilled in the art will readily be able to determine from the following explanations and by routine trial and experiment suitable junction configurations and doping levels which produce this decrease in voltage upon breakdown of the reverse biased junction. We have found by experiment that the junctions should be placed closer to one another than in a comparable example of the aforementioned prior art two junction a.c. device and we postulate that this results in majority carriers from the forward biased junction being swept into the reverse biased junction, in greater numbers with increased surge current, so as to modify the characteristics of the broken down junction and produce the decreasing voltage characteristic which characterizes the present invention.

The device according to the invention has the advantage that because its voltage decreases to a given level after breakdown, the heat generated in the device by a surge current is reduced and the surge current handling capability of the device is correspondingly very great. The device further has the significant and substantial advantage that when coupled in parallel with a circuit for protecting the same from overvoltage surges, the fact that the voltage developed across the device decreases below the breakdown voltage (which by definition must be below the maximum voltage sustainable by the circuit which the device protects) when the device operates to divert a surge from the protected circuit ensures that throughout the duration of the surge the protected circuit is never subjected to a voltage which is even as high as the device breakdown voltage.

Whilst, as will hereinafter be discussed, variation of one or more of the manufacturing parameters of the device according to the invention enables devices to be manufactured consistently and reliably with breakdown voltages within a relatively wide range and up to relatively high values of the order of 150 to 200 volts for example, for applications in the higher voltage areas the invention further proposes, rather than the provision of a single device, to couple together in series two or more devises each of a lower breakdown voltage rating. The resultant composite device has a breakdown voltage substantially corresponding to the sum of the breakdown voltages of the individual devices of the composite multi-device structure.

The invention further provides for two such devices according to the teachings hereof to be electrically contacted with one another and with an electrode formed at the contact therebetween; such a combination device can be used with advantage to replace a conventional gas discharge tube surge arrester for example to protect a pair of telephone lines and their associated circuits against surges.

In order that the invention may be more fully understood embodiments thereof and their operating characteristics will now be described by way of illustrative example and by way of contrast with a prior art device, reference being had to the accompanying drawings wherein:

| Figure 1 | is a graph of the Voltage/current characteristic of a prior art device; |
| Figure 2 | is a schematic diagram of a device according to the invention; |
| Figure 3 | is a graph of the Voltage/current characteristic of a device of Figure 2; |
| Figures 4 to 13 | illustrate the construction of devices according to the invention; |
| Figure 14 | shows a bi-directional device according to the invention; |
| Figure 15 | is a graph of the voltage/current characteristic of a device of Figure 14; |
| Figures 16 to 23 | illustrate another method for producing a device according to the invention. |

In the case of a single Zener diode being incorporated into the chip, the devices are interconnected as shown in Figure 2.

The device consists of a region A representing the single Zener diode and of a region B representing the negative resistance element.

Both the Zener diode and the negative resistance element are integrated onto the same chip. There are also two electrical leads 10, 12 which are bonded to the semiconductor device via metallizations 14, 16. The Zener diode consists of a N-zone 1 and a P-zone 2. The negative resistance element consists of a N-zone 4, a P-zone 5 and a N-zone 6. The device is constructed so that the N-zone 1 of the Zener diode and the N-zone 4 of the negative resistance element are both belonging to the same, N-zone layer 7 of the semiconductor device adjacent to the metallization 16. The P-zone 2 of the Zener diode and the P-zone 5 of the negative resistance element are both belonging to the same P-zone layer 8 of the semiconductor device adjacent to the N-zone layer 8. The other side of the P-zone layer 8 opposite to the N-zone layer 7 is in the area A of the Zener diode covered by the metallization 14 and is in the region B of the negative resistance element adjacent to a N-zone layer 9 which is covered on its side opposite to the P-zone layer 8 by the metallization 14.

The layers 7, 8, 9 may consist of thin planar bodies of silicon of a thickness of the order of a few micrometers to several thousand micrometers. For example, the semiconductor device of Figure 2 may comprise a thin planar body of P-type silicon of thickness of the order of 200 µm for example doped from opposite sides to provide first and second N-type regions 7, 9 of a depth of the order 70 µm for example on either side of the P-type region 8. This arrangement thus provides first and second PN junction arranged in series and with opposite polarities. Electrode layers 14, 16 are formed on opposite sides of the semiconductor device, and it will be appreciated that when a potential difference is applied to the electrodes one of the PN junctions will be forward biased and the other will be reverse biased.

The semiconductor device according to the invention may be connected to a supply voltage source and may be arranged to protect an electric circuit which has maximum and minimum safe rail voltages and the voltage supply must not be allowed to vary outside of these maximum and minimum values.

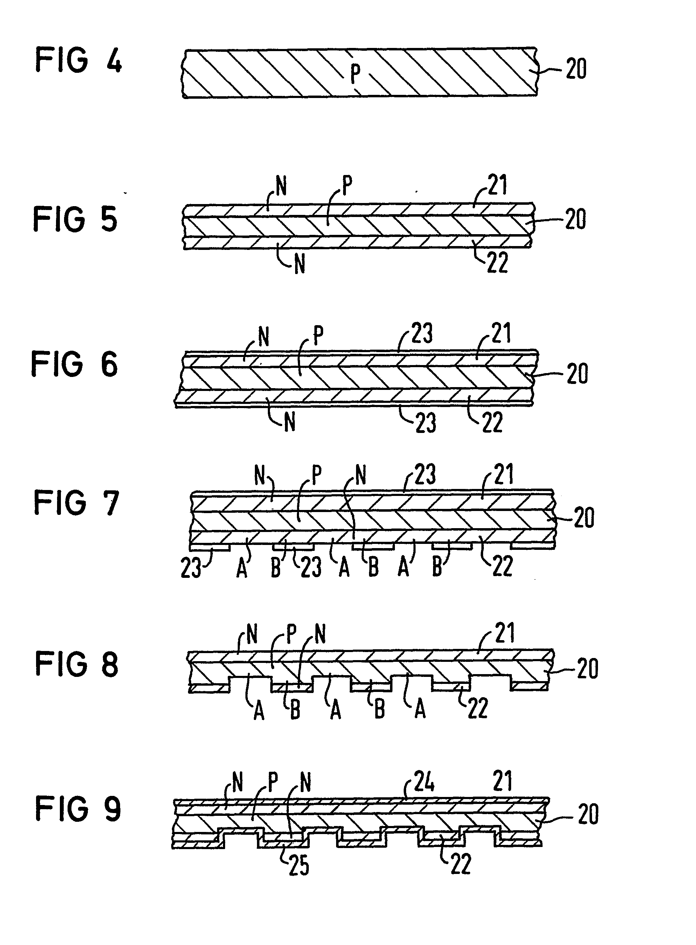

For example, the maximum and minimum safe voltages may be 80 V and 40 V. The supply voltage can be using a bi-directional device (Fig. 5) from a d.c. source and from an a.c. source.

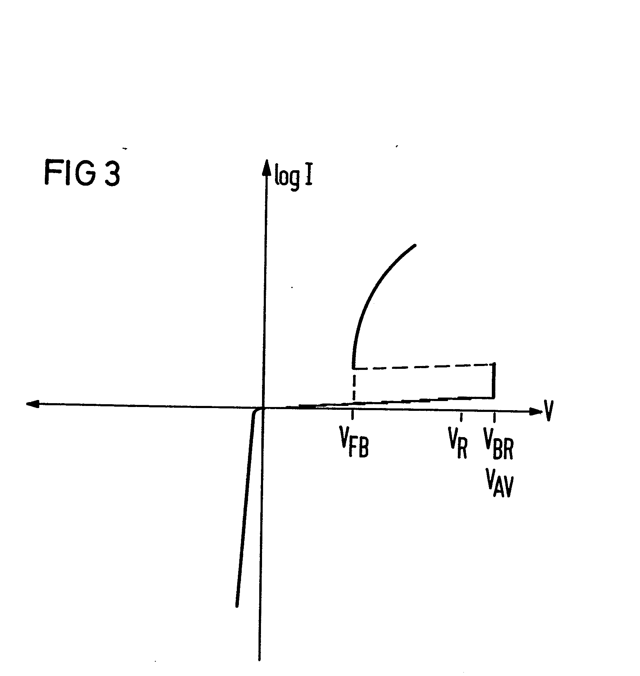

The V/I characteristics of a device made according to the above invention are shown in Figure 3. As the voltage across the device increases, it behaves as a Zener diode with breakdown voltage $V_{BR}$ equal to $V_{AV}$. When the reverse current through the Zener diode rises sufficiently the NPN area B switches so that the voltage across it falls to $V_{FB}$. As the reverse current through the device increases further it behaves similarly to the prior art device.

When a voltage transient occurs in the supply voltage V, such as to apply to the device a voltage exceeding the breakdown voltage $V_{BR}$, the reverse biased junction breaks down and conducts by means of the Avalanche effect. Consequently, the device according to the invention then provides a conductive path for surge currents produced by the voltage transient, and the surge currents thus by-pass an electrical circuit to be protected from being damaged.

When breakdown occurs, the voltage developed across the device rapidly reduces from the device breakdown voltage $V_{BR}$ to a predetermined non-zero value $V_{FB}$ and as the current I increases further, the voltage V remains at the value $V_{FB}$ at least over a considerable range of surge current. It is to be noted that on the graph of Figure 3, the axis representing current I has a non-linear scale. The voltage reduces to $V_{FB}$ when the current increases to approximately 100 mA in this example, and thereafter remains at or approximately at $V_{FB}$ over a large range of current values, typically up to 25 amps of peak current for the transient depending upon the physical size of the device, it being appreciated that a device configured about a relatively small silicon body will saturate sooner than the corresponding device configured about a larger silicon body.

The voltage $V_{FB}$ may be selected by means of control of the doping process used to make the device and principally by control of the proximity to one another of the two PN junctions by control of the dopant diffusion depths and will be selected in dependence upon the characteristics of the circuit 9 to be in excess of the minimum safe supply voltage for the circuit 9. Thus in the example given $V_{FB}$ may for example be selected to be 50 V, i.e. 10 volts greater than the minimum safe supply voltage of 40 V for the circuit 9.

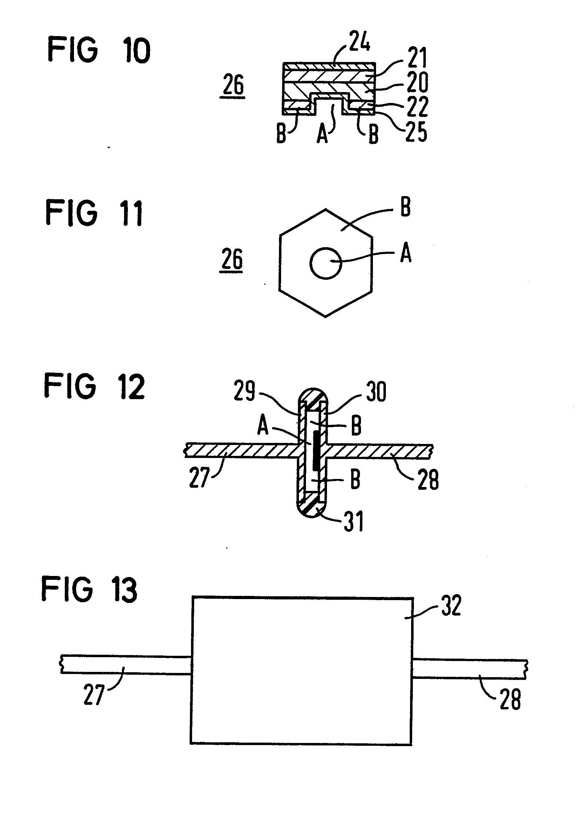

Figure 4 - 13 show the sequence used to construct one embodiment of the invention. P type silicon 20 of resistivity 2 ohm cm (Fig. 4) is diffused with phosphorous

using a $POCl_3$ predeposition process at $1150^\circ$ for 1/2 hour followed by a drive-in for 52 hours. This process will produce N-type regions 21, 22 with diffusion depths of the order of 70 microns (Fig. 5). Both sides of the wafer are coated with photoresist 23 (Fig. 6) and the Zener diode areas A are defined by a photolithographic pattern on one side of the wafer (Fig. 7). In the case discussed a single Zener diode area is defined at the centre of each chip. It is of the same geometrical pattern as that of the chip but a small fraction of the area. In the embodiment being discussed the wafers are cut into hexagonal chips of which 1/8 of the area is area A comprising a central Zener diode and 7/8 of the area is area B comprising peripheral NPN (Fig. 11). The wafers are etched to selectively remove one PN junction at the Zener diode area A, and the photoresist 23 removed (Fig. 8). An Ohmic contact 24, 25 is next applied to the wafers (Fig. 9) and they are then cut into individual chips 26 (Fig. 10, 11).

The embodiment of the invention at present being discussed is a unidirectional device. This device is constructed by soldering the chip to metal electrodes 29, 30, attaching leads 27, 28, etching the silicon to obtain the desired characteristics and then coating the assembly with semiconductor junction coating 31 (Fig. 12). The device is then plastic moulded in a plastic mould 32 (Fig. 13). The device exhibits the V/I characteristics shown in Figure 3.

The values of $V_{BR}$ and $V_{FB}$ and also the shape of a particular device characteristic can be selected by appropriate control of doping and selection of materials and dimensions during the process of manufacture of devices according to the invention. The semiconductor body 20 conveniently comprises a (111) P-type silicon slice doped on both sides with an N-type dopant such as phosphorous, though alternative crystal orientations could be employed and the device could be constructed of N-type base material with P-type dopant. Also a different dopant than phosphorous could be used, though phosphorous is particularly convenient on account of its ease of use and the reliability and consistency of the results. The breakdown voltage of the device is largely dependant upon the bulk resistivity of the silicon body with resistivities within the range 0.95 to 2.4 Ohm $cm^{-3}$ providing $V_{BR}$ values of the order of 60 volts to 170 volts which are currently considered most useful in protective applications of the device. Lower resistivity material could be used to obtain lower $V_{BR}$ values, but there is a limit to the low end resistivities on account of the correspondingly decreased charge carrier lifetime in the material which reduces the availability of free carriers to produce the junction interaction which characterizes the present invention. Likewise, higher resistivities for example of the order of 5 or 6 Ohm $cm^{-3}$ could be used to obtain devices with $V_{BR}$ values around 200 volts but, as previously mentioned herein and as will be further described hereinafter, for such high voltage applications it is considered prefer able to series connect a number of lower voltage devices. The value of $V_{FB}$ is principally a function of the closeness of the two PN junctions in the device which in turn is a function of the thickness of the semiconductor body and the depth of diffusion of the junction forming regions; for example using (111) P-type silicon of thickness 220 $\mu$m (8.5 thou) and diffusing phosphorous to provide N-type regions to a depth of 70 $\mu$m (3 thou) and such that after doping the surface resistance of the N-type regions was around 0.5 to 0.9 Ohm $cm^{-2}$, $V_{BR}$ values useful for a device according to Figure 3 were reliably obtained.

The electrodes preferably are formed as two layer structures 14, 16. The two layerstructures 14, 16 comprise plated deposited Ni, onto which is plated Au layers. The
resulting device can then be mounted between heat dissipating electrodes and encapsulated in a container suitable for direct mounting on a printed circuit board.

It is suggested that the device operates in the following
manner:

When the voltage across the device reaches the breakdown
voltage of the Zener diode region, the device behaves
like a Zener diode in this region. Carriers are generated
by the Avalanche effect in base region 2 (Fig. 3). Some
of these carriers diffuse into the base region 4 of the
NPN device. As the voltage across the device increases
beyond the Zener breakdown voltage, the number of carriers generated rapidly increases until a point is
reached where enough carriers diffuse into the NPN region
to cause this to switch on and behave like the Prior Art
NPN device.

Device can be made to work by this principle by using
both P and N type starting material although P type is
more suitable as the negative resistance effect is much
more pronounced. A wide range of diffusion conditions can
be used to produce devices which operate at pre-determined breakdown voltages and which switch to pre-determined voltage values. The definition of the Zener region A can be achieved by masked diffusion methods
instead of etching. The Zener region A can be a single
area or a number of different areas distributed over the
chip area. It is the geometrical design of these regions
which determines the current at which the device
switches. Too large a percentage of chip area used for
the Zener region A will result in lower than optimum
surge handling capability, too small a Zener region A
will result in a device with low forward current capability. The devices can be passivated before metallisation by glass in moats or by any other method known to those skilled in the art. Passivation can also be carried out by other methods after assembly. Completed devices can be encapsulated in a wide range of housings.

Bi-directional devices can be constructed by placing two chips 33, 34 in series with their polarities reversed as shown in Figure 5. The chips 33, 34 are of the form of the chip 26 in Figure 4. The chip 33 has the electrodes 35, 36 and the chip 34 has the electrodes 36, 37.

A device comprising a number of different Zener Diode areas A can also be produced by an appropriate partitioning of the finished wafer-device according to Figure 9.

The thickness of silicon used determines the surge power capability of the device. The thinner the silicon used the better providing it is thick enough to allow for the diffusion depths and spread of the depletion layer. Mechanical weakness of thin wafers limits the thickness of wafers that can be handled. The silicon will normally have a thickness in the range 150 to 260 microns. Samples processed so far have all used 220 +/-10 micron thick material.

All work carried out so far has used P-type material doped with Boron. Other P-type dopants such as Aluminium or Gallium could be used but they have not been evaluated. In principle N-type material could be used as a starting material, into which a P-type dopant would be introduced. No devices have been made in this manner because the negative resistance effect is very small with such a system (Okano et Al, US Patent 4,262,295). If devices were required to have a small difference between $V_{BR}$ and $V_{FB}$ (confer Figure 3) such a technique might be appropriate.

P-type silicon of resistivity 0.2 to 10 Ohm cm can be used to produce these devices. The resistivity of the starting material will have a major effect on the avalanche voltage of the Zener diode ($V_{BR}$) in a way well known to those skilled in the art of Zener diode manufacture. In the example quoted 2 Ohm cm material leads to a value of $V_{BR}$ of 160 volts.

Phosphorous diffusion conditions should be such to produce diffusion depths in the range of 8 to 80 microns with a surface resistivity after diffusion of 0.1 to 10 Ohms per square. The diffusion depth and concentration profile will affect the avalanche breakdown voltage and slope resistance of the Zener diode region in a manner well known to those skilled in the art of Zener diode manufacture.

Page 12, lines 27 - 29, "The definition of the Zener region can be achieved by masked diffusion methods instead of etching". There are many possible methods of achieving this readily available for those skilled in the art from this disclosure and by routine trial and experiment. One possible method of achieving this is as follows:

The P-type starting material 40 (Figure 16) is oxidized by heating it in the presence of oxygen and water vapour to 1200 $^{\circ}$C for 5 hours (Figure 17). This will produce an oxide 41 1.7 microns thick. Similar process which produce oxides 41 in the range 1 to 2 microns are acceptable. The wafer 40 is coated on one surface with photoresist 42 and a suitable pattern generated in the resist 42 by standard exposure/developing techniques. The pattern is such that the oxide 41 is protected from subsequent etching by resist 42 at the position of the Zener diode shorting in the Zener diode area A (Figure 18). The oxide 41 is re-

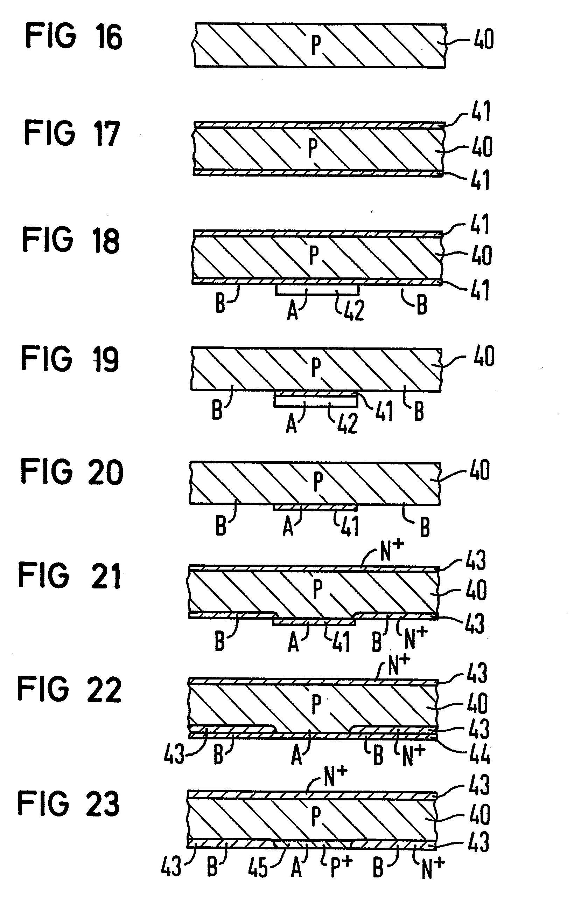

moved from the remaining areas of the wafer 40 by etching
in a mixture of 1 part of 50 % Hydrofluoric acid to 4
parts of 40 % Ammonium fluoride (Figure 19). The photoresist 42 is removed and the wafers 40 cleaned prior to
diffusion (Figure 20). The wafers 40 are given a phosphorous pre-deposition as described previously and a short
'drive-in' diffusion of 5 hours at 1250 $^{\circ}$C (Figure 21).
This process will produce $N^{+}$-type regions 43. All oxide
41 is then removed and the wafer 40 is coated in Boron
spin-on dopant, on the patterned side (Figure 22). This
process produces coating 44. The drive-in diffusion operation is then continued for an additional 47 hours at
1250 $^{\circ}$C to give the required product (Figure 23). In the
areas A previously masked with oxide 41 the Boron forms a
$P^{+}$-contact 45, in the other areas B it does not overdope
the phosphorous because of its lower solid solubility.
The wafers 40 are then Nickel plated and subjected to the
remaining processing steps described in the previous
example (Figure 9 - 13).

Using the additional Boron diffusion step of Figure 22,
there is an additional degree of freedom in connection
with the choice of P-type material 40 and N-type layers
43 diffusion process for adjusting the voltage parameters
$V_{FB}$ and $V_{BR}$ in a manner well known to those skilled in
the art.

Forming of a $P^{+}$-contact in a Zener diode area A can be
useful also in other methods for producing a Zener diode
region.

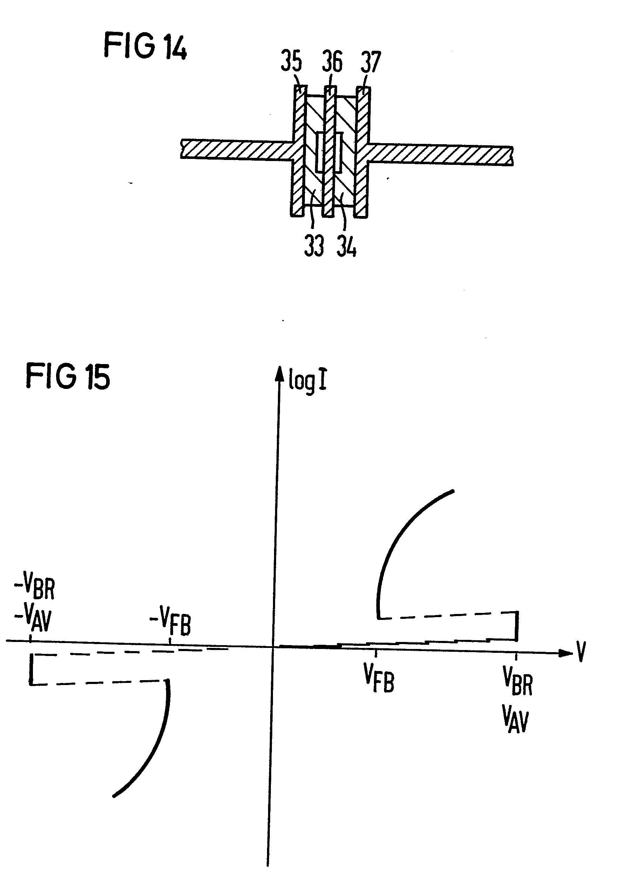

The shorted Zener diode region A must be of sifficient
area to carry the forward current if the device is to be
used in the forward biased mode or if it is to be made
into a bi-directional device (Figure 14). The larger the
shorted area A the lower the reverse current surge capability. A compromise must be made appropriate to the device application. In the case discussed previously 1/8th of the device area shorted appears appropriate.

The distance between shorts must be large enough to prevent areas of the device behaving independently as negative resistance devices similar to the prior art device (Figure 1). For chip sizes up to 0.270'' (0,6858 cm) across corners only one such short has been found to be necessary. For larger devices an increased number of shorts may well be necessary. The effect of increasing the number of shorts and decreasing the distance between them is to increase the current at which the device switches from Avalanche breakdown (Zener region) to negative resistance behavious. A significant increase in this current would lower the reverse current surge capability. For large devices (larger than 0.270'' across corners) it would appear that the number of shorts must be sufficient to ensure device stability without significantly reducing the surge handling capability.

The area of the device determines its surge rating. Hexagonal devices of dimension 0.270'' across corners are capable of withstanding a 1000 Amp exponential pulse, where the current falls to 50 % of its original value in 20 $\mu$s (miscroseconds).Larger surge powers would require a larger device, small surges a smaller device.

23 Figures
13 claims

Claims

1. A transient absorption semiconductor device for presenting a relatively high impedance over a given range of applied voltage and for presenting a low impedance in response to transient voltage excursions from the given range characterized by at least one Zener diode and a negative resistance device integrated onto the same chip so as the semiconductor device behaves as a Zener diode as a voltage across the semiconductor device increases, so as the voltage across the semiconductor device falls to a predetermined non-zero value ($V_{FB}$) when at the breakdown of the Zener diode the reverse current through the Zener diode rises sufficiently and so as for further increasing current, the voltage remains at or approximately at the predetermined non-zero value ($V_{FB}$) over a large range of current values.

2. A device according to claim 1, characterized by a N-P-N negative resistance device.

3. A device according to claim 1 or 2, characterized by two areas (A, B) the first area (A) of which is a Zener diode region and comprises only one PN-junction and the second area (B) of which is a negative resistance element region and comprises two PN-junctions arranged in series and with opposite polarities.

4. A device according to one of the claims 1 to 3, characterized in that the Zener diode region (A) is a number of different areas distributed over the chip area.

5. A device according to one of the claims 1 to 4, characterized by placing two chips (33, 34) in series with their polarities reversed.

6. A device according to one of the claims 1 to 5, characterized by a body (20) of semiconductor material comprising a thin planar body of first conductivity type having in the Zener diode area (A) on one side a region (7) of opposite conductivity type and having in the negative resistance element area (B) on opposite sides thereof regions (7, 9) of opposite conductivity type.

7. A device according to the claim 6, characterized in that said thin planar body has a thickness in the order of 210 $\mu$m.

8. A device according to one of the claims 2 to 7, characterized by a bulk resistivity of the P-type region (8) within the range 0.95 to 2.4 Ohm cm$^{-3}$ and a surface resistivity of the N-type regions (7, 9) of 0.5 to 0.9 Ohm cm$^{-2}$.

9. A device according to one of the claims 1 to 8, characterized by a combination with an electrical circuit, the said device being coupled in parallel with the said electrical circuit for protecting the said circuit from overvoltage transients.

10. Method for producing a device according to one of the claims 1 to 9, characterized by
   a) doping a semiconductor wafer (20) of one conductivity type on opposite sides in order to produce regions of

0203231

- 3 -     VPA 85 P 8021 E

the opposite conductivity type on these opposite sides,

b)   defining Zener diode areas (A) on one side of the wafer,

c)   selectively removing one PN-junction at the Zener diode areas (A),

d)   applying electrical contacts (24, 25) to the wafer, and

e)   cutting the wafer into individual chips (26).


11. Method for producing a device according to one of the claims 1 to 10,
characterized by
soldering the chip (26) to metal electrodes (29, 30),
attaching leads (27, 28),
etching the semiconductor body to obtain the desired characteristics.


12. Method for producing a device according to one of the claims 1 to 9,
characterized by
defining at least one Zener diode area (A) by a masked diffusion process.


13. Method for producing a device according to one of the claims 1 to 12,
characterized by
forming a $P^{+}$-contact in at lease one Zener diode area (A).

FIG 1

$\log I$

$V$

$V_{FB}$   $V_R$   $V_{BR}$   $V_{AV}$

FIG 2

10

16

| 1 | N 7 | 4 |
| 2 | P 8 | 5 |
| | N 9 | 6 |

14

A

12

B

FIG 3

FIG 4

FIG 5

FIG 6

FIG 7

FIG 8

FIG 9

FIG 10

FIG 11

FIG 12

FIG 13

FIG 14

35  36  37

33  34

FIG 15

$\log I$

$-V_{BR}$
$-V_{AV}$   $-V_{FB}$

$V_{FB}$   $V_{BR}$
         $V_{AV}$

$V$

6/6

FIG 16

FIG 17

FIG 18

FIG 19

FIG 20

FIG 21

FIG 22

FIG 23

**European Patent Office**

**EUROPEAN SEARCH REPORT**

EP 85 30 3685

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | DE-A-3 048 816 (HITACHI) * Figures 6,7; page 4, lines 5-18; page 10, line 20 - page 12, line 20; page 17, lines 2-5; figures 12,14 * | 1-3 | H 01 L 29/90 |
| A | | 6 | |
| A | PATENTS ABSTRACTS OF JAPAN, vol. 7, no. 115 (E-176)[1260], May 19, 1983; & JP - A - 58 35 984 (HITACHI SEISAKUSHO K.K.) 02-03-1983 * Abstract; figure * | 4 | |
| D,A | EP-A-0 088 179 (SEMITRON CRICKLADE LTD.) * Figure 1; claims 6,7,10 * | 1,2,7-9 | TECHNICAL FIELDS SEARCHED (Int. Cl.4) |
| A | US-A-4 138 280 (INTERNATIONAL RECTIFIER CORPORATION) * Figures 1-5 * | 10,11 | H 01 L |
| D,A | US-A-4 262 295 (HITACHI LTD.) * Figures 1,5,10; page 4, lines 9-39 * | 4,12 | |
| | --- -/- | | |

The present search report has been drawn up for all claims

| Place of search | Date of completion of the search | Examiner |
|---|---|---|
| THE HAGUE | 30-01-1986 | GELEBART J.F.M. |

# EUROPEAN SEARCH REPORT

**European Patent Office**

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| A | PATENTS ABSTRACTS OF JAPAN, vol. 6, no. 151 (E-124)[1029], August 11, 1982; & JP - A - 57 72 389 (HITACHI SEISAKUSHO K.K.) 06-05-1982 * Abstract; figure * | 13 | |

-----

**TECHNICAL FIELDS SEARCHED (Int. Cl.4)**

The present search report has been drawn up for all claims

| Place of search | Date of completion of the search | Examiner |
|---|---|---|
| THE HAGUE | 30-01-1986 | GELEBART J.F.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82